# EUROPEAN PATENT APPLICATION

(11) **EP 0 749 169 A2**
(43) Date of publication of application: **18.12.1996**
(21) Application number: 96109427.3
(22) Date of filing: 12.06.1996
(51) Int. Cl.: H01L 31/107

(54) **Semiconductor light receiving element for use in optical communication**

(30) Priority: 14.06.1995 JP 147330/95
(71) Applicant: NEC CORPORATION, Tokyo (JP)
(72) Inventor: Kusakabe, Atsuhiko, Tokyo (JP)
(74) Representative: Glawe, Delfs, Moll & Partner

(57) **Abstract**

A semiconductor light receiving element for use in monitoring an optical communication fiber network has high quantum response, low dark current and high current multiplying efficiency for light having wavelength of 1.65 µm. The semiconductor light receiving element comprises an InP substrate, an InP buffer layer formed on one surface of the InP substrate, an n-InAsP buffer layer formed on the InP buffer layer, a distortion InGaAs light absorbing layer formed on the n-InAsP buffer layer and having wavelength of 1.85 µm, an InGaAs linear step layer formed on the distortion InGaAs light absorbing layer and having wavelength changing from 1.85 µm to 1.67 µm, an InGaAs intermediate layer formed on the InGaAs linear step layer, an n-InP multiplying layer formed on the InGaAs intermediate layer and an InP window layer formed on the multiplying layer. Light having wavelength of 1.65 µm and incident on the window layer side is absorbed by the distortion InGaAs light absorbing layer, converted into carrier by photoelectric conversion and flows to an external circuit. Dark current produced by lattice mismatching between the InP layer and the InGaAs layer can be restricted by providing the InAsP layer therebetween.

## Description

### BACKGROUND OF THE INVENTION

### Field of the Invention

The present invention relates to a semiconductor light receiving element for use in an optical measurement or optical communication and, particularly, to a semiconductor light receiving element for use in such as circuit monitor of an optical fiber network for optical communication, which is used in a wide wavelength band.

### Description of the Prior Art

It has been known that optical fibers are laid as an optical communication circuit. The Optical Time Domain Reflectometer (OTDR) is a typical maintenance device for maintaining such optical fiber network. The OTDR is used to check a broken point of an optical fiber which is laid as a circuit network and is operated on the basic principle which will be described. That is, Rayleigh scattering light which is produced when light pulse incident into the optical fiber propagates through the optical fiber is monitored.

When there is a broken point in the optical fiber, Rayleigh scattering light can not be reflected back therefrom. Thus, an exact position of the broken point can be known by converting a time period from a time at which the light pulse is supplied to a time at which Rayleigh scattering light disappears into a physical distance.

In this case, however, the communication circuit has to be connected to the OTDR by temporarily opening the communication circuit. In order to solve this problem, it has been proposed to continuously monitor a communication circuit while the latter is being used, by using a monitoring light having a wavelength band centered at 1.65 µm which differs from wavelength of 1.3 µm or 1.55 µm which is used for the optical communication.

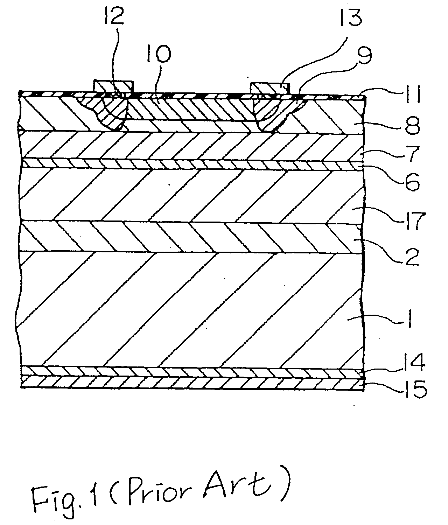

As a semiconductor light receiving element for use in such continuous monitoring system, the so-called avalanche photodiode (referred to as APD, hereinafter) has been used popularly. Since the APD itself has an amplifying function, it has been used widely in the optical measurement and/or optical communication as a high sensitivity light receiving element. Among others, InP/InGaAs has been used as a material of a semiconductor light receiving element for use in a large capacity, long distance optical communication which uses light having the wavelength band centered at 1.3 µm or 1.55 µm. Fig. 1 shows a first example of the conventional semi-conductor light receiving element using this material.

In Fig. 1 which is a cross section showing the example of the APD using InGaAs, an n⁺-InP buffer layer 2, an n⁻-In_{0.53}Ga_{0.47}As light absorbing layer 17, an n-InGaAsP intermediate layer 6, an n⁺-InP multiplying layer 7 and an n⁺-InP window layer 8 are epitaxially grown sequentially in the order on an n⁺-InP substrate 1. Further, a p⁺-InP region 10 is selectively formed on the n⁺-InP window layer 8 as a light receiving portion and a guard ring 9 surrounding the light receiving portion is formed. When the APD using InGaAs is reverse-biased, a depletion layer spreads in the InGaAs light absorbing layer 17. In this case, when light having a wavelength of, for example, 1.3 µm which is smaller than 1.67 µm corresponding to the band gap energy of the InGaAs layer 17 is incident thereon, carrier is produced in the depleted light absorbing layer 17 due to photoelectric effect. The carrier thus produced is accelerated up to the saturation speed by an internal electric field of 20 ∼ 100 kV/cm in the depletion layer and flows into an external circuit as current.

What is the problem in this case is that although the absorption end wavelength of the light absorbing layer 17 which is formed of n⁻-InGaAs is 1.67 µm, which provides no problem of sensitivity to light having wavelength of 1.3 µm or 1.55 µm used to transmit data through the optical communication, its sensitivity to the continuous monitoring wavelength of 1.65 µm is low, since the latter wavelength is in the vicinity of the absorption end wavelength of the light absorbing layer of 1.67 µm and quantum efficiency thereof becomes about 20%. A second example of the conventional semiconductor light receiving element has been proposed to solve the above problem and to receive a light having a longer wavelength.

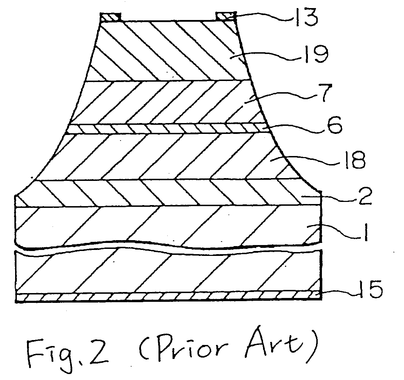

The second example is shown in Fig. 2. In Fig. 2, an n⁺-InP buffer layer 2 is formed on an n⁺-InP substrate 1 and an n⁻-InAs/GaAs super lattice light absorbing layer 18, an n⁻-InGaAsP layer 6, an n⁺-InP multiplying layer 7 and a p-InP layer 19 are grown on the n⁺-InP buffer layer 2 sequentially in the order. The wafer is mesa-etched and then TiPtAu and AuGeNi are vapor deposited thereon as a p electrode 13 and an n electrode 15, respectively, resulting in the second example of the conventional light receiving element. With the light absorbing layer having the superlattice layer structure of InAs and GaAs, it is possible to expend the absorption end wavelength up to 3.2 µm.

What is the problem in the case of the second example is that lattice mismatching occurs in an interface of the superlattice of InAs and GaAs on the InP substrate, causing dark current to be produced by the lattice defect and that the sensitivity is lowered by noise generated by the dark current.

### SUMMARY OF THE INVENTION

An object of the present invention is to provide a semiconductor light receiving element capable of receiving light having wide wavelength range.

Another object of the present invention is to provide a semiconductor light receiving element capable of obtaining high quantum efficiency, low dark current and high current multiplying rate with respect to long wavelength light.

A further object of the present invention is to provide a semiconductor light receiving element suitable for in a circuit monitor for monitoring an optical communication fiber network.

Another object of the present invention is to provide a semiconductor light receiving element capable of obtaining high quantum efficiency, low dark current and high current multiplying rate with respect to light having wavelength of 1.65 µm as well as light having wavelength of 1.3 µm or 1.5 µm.

In order to achieve the above objects, according to the present invention, a semiconductor light receiving element is provided which comprises a hetero epitaxial layer structure comprising a first conductivity type InP substrate and a first conductivity type InAsP layer, a first conductivity type In_{0.57}Ga_{0.43}As light absorbing layer (λ = 1.85 µm), a first conductivity type InP multiplying layer and a first conductivity type InP window layer formed on the first conductivity type InP substrate sequentially in the order, a structure including a second conductivity type InP region provided partially in the window layer or the multiplying layer, a second conductivity type electrode formed on the second conductivity type InP region provided in the window layer and a first conductivity type electrode formed on the first conductivity type InP substrate.

Thickness of the first conductivity type In_{0.57}Ga_{0.43}As light absorbing layer is 2 µm to 5 µm.

An intermediate layer is provided between the In_{0.57}Ga_{0.43}As light absorbing layer and the first conductivity type InP multiplying layer. The intermediate layer has constituents whose ratio changes continuously from one corresponding to wavelength of 1.85 µm to another corresponding to wavelength of 1.67 µm.

In the present invention, it is possible to shift the absorption end toward ultra long wave side, to restrict the lattice mismatching and to reduce noise by employing the hetero epitaxial layer structure including the distortion n-InGaAs light absorbing layer, the n-InAsP buffer layer on the substrate side of the distortion n-InGaAs light absorbing layer, the n-InGaAs linear step layer and the n-InGaAs intermediate layer on the respective multiplying and window layer sides, whose constituent ratio changes from one corresponding to wavelength of 1.85 µm to another corresponding to wavelength of 1.67 µm. As a result, the semiconductor light receiving element according to the present invention exhibits high sensitivity to light having long wavelength and can obtain high photo-multiplication rate at such wavelength.

### BRIEF DESCRIPTION OF THE DRAWINGS

Fig. 1 is a cross sectional view showing a conventional semiconductor light receiving element;
Fig. 2 is a cross sectional view showing another conventional semiconductor light receiving element;
Fig. 3 is a cross sectional view showing a semiconductor light receiving element according to a first embodiment of the present invention;
Fig. 4 is a cross sectional view showing a semiconductor light receiving element according to a second embodiment of the present invention;
Fig. 5 shows a sensitivity distribution of the semiconductor light receiving element according to the first embodiment of the present invention; and
Fig. 6 is a graph showing a relation between dark current and x value of InₓGa₁₋ₓAs.

### DESCRIPTION OF THE PREFERRED EMBODIMENTS

The present invention will be described in more detail with reference to embodiments shown in the accompanying drawings.

### EMBODIMENT 1:

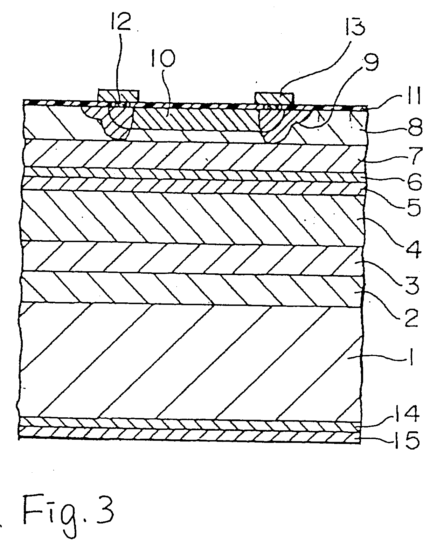

Fig. 3 shows a first embodiment of a semiconductor light receiving element according to the present invention.

In Fig. 3, on a surface of an n⁺-InP substrate 1, an n⁺-InP buffer layer 2 whose carrier density is preferably 1E15 ∼ 2E16 cm⁻³ and whose thickness is preferably 1 ∼ 3 µm is grown by epitaxy. In this embodiment, carrier density and thickness were 1E15 cm⁻³ and 2 µm, respectively. Then, in order to relax lattice mismatching, an n-InAsP buffer layer 3 having carrier density of preferably 1E15 ∼ 2E16 cm⁻³ and thickness of preferably 1 ∼ 3 µm is grown on the n⁺-InP buffer layer 2. In this embodiment, carrier density and thickness of the n-InAsP buffer layer 3 were 1E15 cm⁻³ and 2 µm, respectively.

As a light absorbing layer for a long wave light, a distortion n⁻-In₀ ₅₇Ga₀ ₄₃As (λ = 1.85 µm) light absorbing layer 4 having end wavelength λ = 1.85 µm of light absorption range, carrier density of preferably 1E15 ∼ 5E15 cm⁻³ and thickness of preferably 3 ∼ 4 µm is grown on the buffer layer 3. In this embodiment, carrier density and thickness of the distortion n⁻-InGaAs light absorbing layer 4 were 3E15 cm⁻³ and 4 µm, respectively.

In order to further relax lattice mismatching, a distortion n-InGaAs linear step layer 5 having carrier density of preferably 3E15 ∼ 1E16 cm⁻³, thickness of preferably 0.03 ∼ 0.5 µm and absorption end wavelength changing continuously from 1.85 µm to 1.67 µm is formed on the distortion light absorbing layer 4 by forming layers of n⁻-In_{0.57}Ga_{0.43}As to n-In_{0.53}Ga_{0.47}As, sequentially. In this embodiment, carrier density and thickness of the n-InGaAs linear step layer 5 were 1E16 cm⁻³ and 0.5 µm, respectively.

Thereafter, an n-InGaAs intermediate layer 6 having carrier density of preferably 3E15 ∼ 1E16 cm⁻³ and thickness of preferably 0.03 ∼ 0.5 µm is formed on the linear step layer 5 and then an n⁺-InP multiplying layer 7 having carrier density of preferably 1E16 ∼ 4E16 cm⁻³ and thickness of preferably 0.5 ∼ 3 µm is grown on the intermediate layer 6. In this embodiment, carrier density and thickness of the n-InGaAs intermediate layer 6 were 1E16 cm⁻³ and 0.5 µm, respectively, and carrier density and thickness of the n⁺-InP multiplying layer 7 were 3E16 cm⁻³ and 1.4 µm, respectively. Finally, an n⁻-InP window layer 8 having carrier density of preferably 2E15 ∼ 6E15 cm⁻³ and thickness of preferably 1 ∼ 2 µm is grown on the multiplying layer 7. In this embodiment, carrier density and thickness of the window layer were 5E15 cm⁻³ and 1.4 µm, respectively.

On a surface of the epitaxial wafer thus formed, a mask is grown by chemical vapor deposition (CVD) and a guard ring 9 is formed by injecting, for example, Be ion through the mask. Then, a diffusion mask is opened such that it overlaps the guard ring 9 and a p⁺ region 10 corresponding to a light receiving portion is selectively formed by seal diffusion of, for example, Zn. Thereafter, an insulating film 11 such as SiNx film or SiO₂ film is grown on the surface side thereof by using ordinary method and then a portion of the insulating film 11 on the p⁺-region 10 is opened. After a p side contact electrode 12 is formed thereon by, for example, vapor deposition, the wafer is heat-treated. Then, a p side electrode 13 covering the p side contact electrode is formed.

Then, after an n side contact electrode 14 is formed on a rear surface of the n⁺-InP substrate 1 by, for example, vapor deposition, the wafer is heat-treated. Finally, an n side electrode 15 covering the n contact electrode 14 is formed.

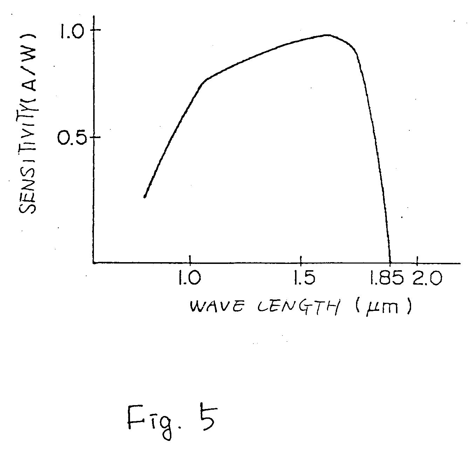

A spectral response characteristics of the distortion InGaAs-APD thus fabricated is shown in Fig. 5. When light having wavelength of 1.65 µm is incident on this APD, the light penetrates through the window layer 8 into the P⁺ diffusion region 10 and, after it penetrates the light multiplying layer 7, the intermediate layer 6 and the distortion n-InGaAs linear step layer 5, it is absorbed by the distortion light absorbing layer 4. Carrier produced by light absorbed therein is accelerated by an electric field applied between the p side electrode 13 and the n side electrode 15 and flows through the p side electrode 13 to an external circuit as photocurrent.

With this structure, it is possible to absorb light having wavelength of 1.65 µm with efficiency as high as 70% or more. Further, by providing the n-InP buffer layer 2 and the n-InAsP buffer layer 3 between the distortion n⁻-InGaAs light absorbing layer 4 and the n⁺-InP substrate 1, it is possible to restrict lattice mismatching, so that a low dark current characteristics as low as 100 nA or less can be obtained.

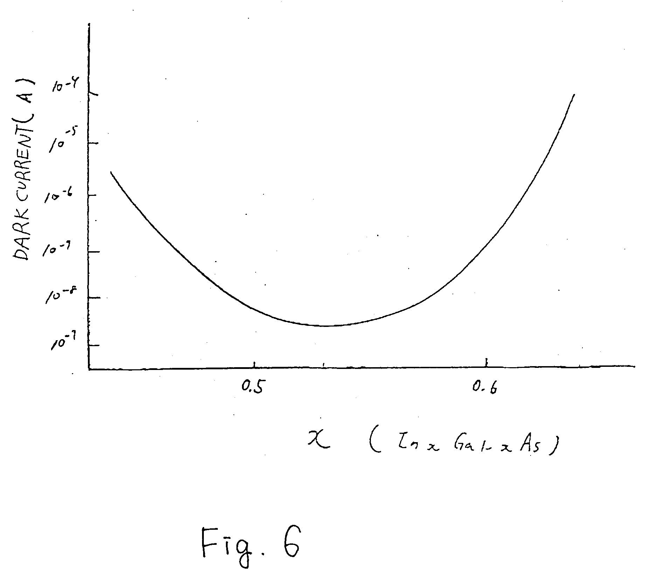

Fig. 6 shows a relation between x value and dark current of InₓGa₁₋ₓAs. It is clear from Fig. 6 that, when the x value exceeds 0.57, dark current increases to the extent that it can not be used to fabricate an OTDR.

Further, carrier produced in the distortion n⁻-InGaAs light absorbing layer 4 due to the above-mentioned effect is multiplied by 30 times or more by the electric field applied to the n⁺-InP multiplying layer 7.

In the present invention, the desired characteristic of the OTDR is obtained by using the hetero epitaxial layer of InGaAsP system. It has been found that such characteristics can not be obtained when the hetero epitaxial layer of other material system than InGaAsP is used.

The above-mentioned effect may be obtained by a wafer formed by other method than gas phase epitaxy. For example, an epitaxial wafer formed by using CVD, metal organic chemical vapor deposition (MOCVD), molecular beam epitaxy (MBE) or ALE exhibits similar effect to that obtained by gas phase epitaxy.

### EMBODIMENT 2:

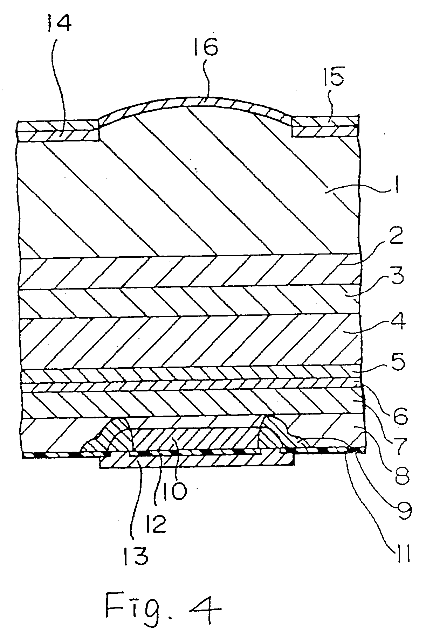

Fig. 4 shows a second embodiment of the semiconductor light receiving element according to the present invention.

In Fig. 4, on a surface of an n⁺-InP substrate 1, an n⁺-InP buffer layer 2 whose carrier density is preferably 1E15 ∼ 2E16 cm⁻³ and whose thickness is preferably 1 ∼ 3 µm is grown by epitaxy. In this embodiment, carrier density and thickness were 1E15 cm⁻³ and 2 µm, respectively. Then, in order to relax lattice mismatching, an n-InAsP buffer layer 3 having carrier density of referably 1E15 ∼ 2E16 cm⁻³ and thickness of preferably 1 ∼ 3 µm is grown on the n⁺-InP buffer layer 2. In this embodiment, carrier density and thickness of the n-InAsP buffer layer 3 were 1E15 cm⁻³ and 2 µm, respectively.

As a light absorbing layer for a long wavelength light, a distortion n⁻-InGaAs (λ = 1.85 µm) light absorbing layer 4 having end wavelength λ = 1.85 µm of light absorption range, carrier density of preferably 1E15 ∼ 5E15 cm⁻³ and thickness of preferably 3 ∼ 4 µm is grown on the buffer layer 3. In this embodiment, carrier density and thickness of the distortion n⁻-InGaAs light absorbing layer 4 were 3E15 cm⁻³ and 4 µm, respectively.

In order to further relax lattice mismatching, a distortion n-InGaAs linear step layer 5 having carrier density of preferably 3E15 ∼ 1E16 cm⁻³, thickness of preferably 0.03 ∼ 0.5 µm and absorption end wavelength changing continuously from 1.85 µm to 1.67 µm is formed on the distortion light absorbing layer 4. In this embodiment, carrier density and thickness of the n-InGaAs linear step layer 5 were 1E16 cm⁻³ and 0.5 µm, respectively.

Thereafter, an n-InGaAs intermediate layer 6 having carrier density of preferably 3E15 ∼ 1E16 cm⁻³ and thickness of preferably 0.03 ∼ 0.5 µm is formed on the linear step layer 5 and then an n⁺-InP multiplying layer 7 having carrier density of preferably 1E16 ∼ 4E16 cm⁻³ and thickness of preferably 0.5 ∼ 3 µm is grown on the intermediate layer 6. In this embodiment, carrier density and thickness of the n-InGaAs intermediate layer 6 were 1E16 cm⁻³ and 0.5 µm, respectively, and carrier density and thickness of the n⁺-InP multiplying layer 7 were 3E16 cm⁻³ and 1.4 µm, respectively. Finally, an n⁻-InP window layer 8 having carrier density of preferably 2E15 ∼ 6E15 cm⁻³ and thickness of preferably 1 ∼ 2 µm is grown on the multiplying layer 7. In this embodiment, carrier density and thickness of the window layer were 5E15 cm⁻³ and 1.4 µm, respectively.

On a surface of the epitaxial wafer thus formed, a mask is grown by CVD and a guard ring 9 is formed by, for example, Be ion injection through the mask. Then, a diffusion mask is opened such that it overlaps the guard ring 9 and a p⁺ region 10 corresponding to a light receiving portion is selectively formed by seal diffusion of, for example, Zn. Thereafter, an insulating film 11 is grown on a rear surface side thereof by using ordinary method and then a portion of the insulating film 11 on the p⁺-region 10 is opened. After a p side contact electrode l2 is formed thereon by, for example, vapor deposition, the wafer is heat-treated. Then, a p side electrode 13 covering the p side contact electrode is formed.

Then, the surface of the n⁺-InP substrate 1 is chemically etched to provide a convex land having redius of 120 to 150 µm as a lens and an anti-reflection film 16 is formed on a surface of the convex lens. After an n side contact electrode 14 surrounding the convex lens is formed on the surface of the n⁺-InP substrate 1 by, for example, vapor deposition, the wafer is heat-treated. Finally, an n side electrode 15 covering the n contact electrode 14 is formed.

When light having wavelength of 1.65 µm is incident on the rear surface of the InGaAs-APD thus fabricated, the light passed through the lens penetrates through the n⁺-InP substrate 1, the InP buffer layer 2 and the n-InAsP buffer layer 3 and absorbed by the distortion n⁻-InGaAs light absorbing layer 4. Carrier produced by light absorbed therein flows through the n-InGaAs linear step layer 5, the n-InGaAsP intermediate layer 6, the n⁺-Inp multiplying layer 7, the n⁻-InP window layer 8 and the p⁺-InP layer 10 to the p side electrode 13 from which it flows to an external circuit.

With this structure, it is possible to absorb light having wavelength of 1.65 µm with efficiency as high as 70% or more. Further, by providing the n-InP buffer layer 2 and the n-InAsP buffer layer 3 between the distortion n⁻-InGaAs light absorbing layer 4 and the n⁺-InP substrate 1, it is possible to restrict lattice mismatching, so that a low dark current characteristics as low as 100 nA or less can be obtained.

Further, carrier produced in the distortion n⁻-InGaAs light absorbing layer 4 due to the above-mentioned effect is multiplied by 30 times or more by the electric field applied to the n⁺-InP multiplying layer 7.

The above-mentioned effect may be obtained by a wafer formed by other method than gas phase epitaxial growth. For example, an epitaxial wafer formed by CVD, MOCVD, MBE or ALE exhibits similar effect to that obtained by the gas phase epitaxial growth.

As described hereinbefore, according to the present invention, it is possible to absorb light having wavelength of 1.65 µm with efficiency as high as 70% or more in the distortion n⁻-InGaAs light absorbing layer. Further, since it is possible to restrict lattice mismatching, a dark current characteristics as low as 100 nA or less can be obtained. Further, carrier produced in the distortion n⁻-InGaAs light absorbing layer 4 can be multiplied by 30 times or more by the electric field applied to the n⁺-InP multiplying layer 7.

## Claims

1. A semiconductor light receiving element comprising:
a hetero epitaxial layer structure having sequentially formed layers of a first conductivity type InP substrate;
a first conductivity type InAsP layer, a first conductivity type In_{0.57}Ga_{0.43}As light absorbing layer, a first conductivity type InP multiplying layer, and a first conductivity type InP window layer;
a second conductivity type InP region provided partially in at least one of said window layer and said multiplying layer; and
a pair of electrodes formed on top and bottom of said structure.

2. A semiconductor light receiving element claimed in claim 1, wherein thickness of said light absorbing layer is 2 µm to 5 µm.

3. A semiconductor light receiving element claimed in claim 1, further comprising an intermediate layer provided between said light absorbing layer and said multiplying layer, said intermediate layer has a composition ratio changing continuously from one corresponding to wavelength of 1.85 µm to another corresponding to wavelength of 1.67 µm.

4. A semiconductor light receiving element comprising:
a first conductivity type InP substrate;
a first conductivity type InP buffer layer formed on one surface of said substrate;
a first conductivity type InAsP buffer layer formed on said InP buffer layer;
a first conductivity type InGaAs light absorbing layer formed on said InAsP buffer layer;
a first conductivity type distortion linear step layer formed on said InGaAs light absorbing layer;
a first conductivity type InGaAsP intermediate layer formed on said distortion linear step layer;
a first conductivity type InP multiplying layer formed on said InGaAsP intermediate layer;
a first conductivity type InP window layer formed on said InP multiplying layer;
a second conductivity type region formed in said InP window layer;
a first electrode formed on said second conductivity type region; and
a second electrode formed on the other surface of said substrate.

5. A semiconductor light receiving element claimed in claim 4, wherein said light absorbing layer consists of In_{0.57}Ga_{0.43}As.

6. A semiconductor light receiving element claimed in claim 4, wherein a composition ratio of said distortion linear step InGaAs layer is ranged from In₀ ₅₇Ga₀ ₄₃AS to In_{0.53}Ga_{0.47}As.
